# EUROPEAN PATENT APPLICATION

(11) **EP 3 460 544 A1**
(43) Date of publication of application: **27.03.2019**
(21) Application number: 17192881.5
(22) Date of filing: 25.09.2017
(51) Int. Cl.: G02B 6/12, H01S 5/14, H01S 5/026, H01S 5/0625

(54) **INTEGRATED PHOTONIC ASSEMBLY AND METHOD FOR FABRICATING THE SAME**

(71) Applicant: EFFECT Photonics B.V., 5617 BC Eindhoven (NL)
(72) Inventor: KLEIJN, Emil, 5617 BC Eindhoven (NL)
(74) Representative: Renkema, Jaap

(57) **Abstract**

The invention relates to an integrated photonic assembly (1) for optical monitoring purposes, comprising at least one reflecting device (2) for reflecting electromagnetic radiation using total internal reflection that comprises a first waveguide section (3) having first (4) and second (5) end parts arranged opposite to each other, the first end part being provided with at least one optical input/output port (6), the second end part comprising at least a first pair of 45 degree mirrors (7) arranged to reflect incident electromagnetic radiation towards the at least one optical input/output port, wherein the second end part is provided with an optical monitor port (8) arranged between nearest end parts of the 45 degree mirrors of said at least first pair and configured to receive a portion of the electromagnetic radiation in the first waveguide section, and at least one photodetector component (9) that is in optical communication with the optical monitor port and is configured to detect said portion of electromagnetic radiation in the optical monitor port.

The invention also relates to an integrated semiconductor laser device (10) comprising the integrated photonic assembly according to the invention, wherein the at least one reflecting device is arranged as a reflector of the integrated semiconductor laser device.

The invention further relates to a photonic integrated circuit (PIC) comprising at least one of the integrated photonic assembly and the integrated semiconductor laser device according to the invention.

The invention even further relates to a method for fabricating the integrated photonic assembly according to the invention.

## Description

### FIELD OF THE INVENTION

The present invention relates to an integrated photonic assembly having optical monitoring capability. The invention also relates to an integrated semiconductor laser device comprising the integrated photonic assembly. In addition, the invention relates to a photonic integrated circuit comprising at least one of the integrated photonic assembly and the integrated semiconductor laser device. Furthermore, the invention relates to a method for fabricating the integrated photonic assembly set forth.

### BACKGROUND OF THE INVENTION

Integrated photonic assemblies comprising reflecting devices for reflecting electromagnetic radiation using total internal reflection are known in the art. An example of a reflecting device that is used in such assemblies is a Multimode Interference Reflector (MIR) that comprises a waveguide section that is designed to act as a multimode section having a first end part and a second end part that are arranged opposite to each other. The first end part of the waveguide section is provided with at least one optical input/output port. Electromagnetic radiation that enters the waveguide section is replicated at regular intervals to provide one or more, preferably two, self-images due to the multimode effect inside the waveguide section. The second end part of the waveguide section comprises two 45 degree mirrors that are arranged to achieve low-loss reflection of the two images towards the at least one optical input/output port at the first end part of the waveguide section. Theoretically, reflections up to 100% can be obtained.

In practice however, due to limited lithographical resolution, the point where nearest end parts of the two 45 degree mirrors meet, is commonly not well defined and in practice is more like a rounded region. Although in a properly designed MIR the amount of electromagnetic radiation that ends up in this rounded region is minimal, it never equals zero. The small amount of electromagnetic radiation that during operation of the MIR ends up in this rounded region is scattered out of the waveguide section of the MIR and therefore is lost.

### SUMMARY OF THE INVENTION

It is an object of the present invention to provide an integrated photonic assembly comprising at least one reflecting device that is configured to enable optical monitoring by using the abovementioned small amount of electromagnetic radiation that is scattered out of the waveguide section of MIRs known in the art at the rounded region between nearest end parts of the two 45 degree mirrors.

It is also an object of the present invention to provide an integrated semiconductor laser device that comprises the integrated photonic assembly according to the invention.

It is another object of the present invention to provide a photonic integrated circuit comprising at least one of the integrated photonic assembly and the integrated semiconductor laser device according to the invention.

Furthermore, it is an object of the present invention to provide a method for fabricating the integrated photonic assembly according to the invention.

Aspects of the present invention are set out in the accompanying independent and dependent claims. Features from the dependent claims may be combined with features from the independent claim as appropriate and not merely as explicitly set out in the claims.

At least one of the abovementioned objects is achieved by an integrated photonic assembly for optical monitoring purposes, comprising at least one reflecting device for reflecting electromagnetic radiation using total internal reflection, comprising a first waveguide section having a first end part and a second end part that are arranged opposite to each other, the first end part being provided with at least one optical input/output port, the second end part comprising at least a first pair of 45 degree mirrors that is arranged to reflect incident electromagnetic radiation towards the at least one optical input/output port, wherein the second end part is provided with an optical monitor port that is arranged between nearest end parts of the 45 degree mirrors of said at least first pair and is configured to receive a portion of the electromagnetic radiation in the first waveguide section, and at least one photodetector component that is in optical communication with the optical monitor port and is configured to detect said portion of electromagnetic radiation in the optical monitor port.

By arranging an optical monitor port between the nearest end parts of the 45 degree mirrors of said at least first pair at the second end part of the first waveguide section of the at least one reflecting device, electromagnetic radiation that would otherwise be scattered out of the first waveguide section at this point can be captured and used for optical monitoring purposes. Examples of such monitoring purposes include, monitoring of the amount of optical power that is reflected and/or estimating optical output power of a device, e.g. a laser device, with which the reflecting device of the integrated photonic assembly is in optical communication. The person skilled in the art will appreciate that the integrated photonic assembly enables to monitor the performance of a device with which it is in optical communication while the device is operating. Furthermore, the optical monitor port can be added to any MIR, regardless of the number of optical input/output ports. The person skilled in the art will appreciate that there are no inherent limitations associated with the integrated photonic assembly according to the invention regarding the placement of the assembly on a photonic integrated chip (PIC) or on an optical bench.

The person skilled in the art will appreciate that the at least one reflecting device of the integrated optical assembly according to the invention can have N pairs of 45 degree mirrors, wherein N is an integer. At least one of the N pairs can be provided with an optical monitor port that is arranged between the nearest end parts of the 45 degree mirrors of said at least one pair. The optical monitor port can be in optical communication with at least one photodetector component.

If the integrated optical assembly according to the invention has more than one reflecting device, more than one optical monitor port and more than one photodetector component, at least one of the reflecting devices is provided with one optical monitor port that is in optical communication with at least one photodetector component. The person skilled in the art will appreciate that many configurations of the integrated photonic assembly can be envisaged that can be used in advantageous ways.

In an embodiment of the integrated photonic assembly according to the invention, the optical monitor port comprises at least a second waveguide section that is arranged between said nearest end parts of the 45 degree mirrors of said at least first pair and that has a width in a range of 10% to 20% of a width of the first waveguide section. The width of the second waveguide section determines the portion of the electromagnetic radiation that is tapped from the first waveguide section. This provides a design parameter that can be set depending on the requirements of a specific application. When choosing the width of the second waveguide section in the range mentioned above, the tapped portion of electromagnetic radiation is equal to or at least comparable with the amount of electromagnetic radiation that is scattered out of the first waveguide section of a known reflecting device having a rounded point between the nearest end parts of the 45 degree mirrors of said at least first pair. In this way, the monitoring capability can be achieved without introducing any additional losses or at most low additional losses when compared to known reflecting devices lacking this capability. Furthermore, the person skilled in the art will appreciate that many configurations of the optical monitor port can be envisaged that can be used in advantageous ways.

In an embodiment of the integrated photonic assembly according to the invention, the at least one reflecting device is a Multimode Interference Reflector (MIR). The person skilled in the art will appreciate that the first waveguide section of a MIR is designed to act as a multimode section. By tapering the first waveguide section of a MIR the ratio between reflection and transmission can be set. In addition, a main advantage of MIRs is their ease of fabrication when compared to for example Distributed Bragg Reflectors (DBRs). Furthermore, MIRs are very fabrication tolerant and can be fabricated in the same fabrication steps as deep-etched waveguides.

In an embodiment of the integrated photonic assembly according to the invention, the integrated photonic assembly is integrated on a substrate comprising at least one of a III-V semiconductor material, a silicon-based material, more particularly Silicon-On-Insulator (SOI), a glass substrate and any dielectric material having a critical reflection angle larger than 45 degrees. The person skilled in the art will appreciate that when using at least one of a III-V semiconductor material and a silicon-based material, more particularly SOI as a substrate, the integrated photonic assembly can either be integrated monolithically or in a hybrid way. Whereas, when using at least one of a glass substrate and any dielectric material having a critical reflection angle larger than 45 degrees, the integrated photonic assembly can only be integrated in a hybrid way because of the at least one photodetector component that requires the application of a semiconductor material. Furthermore, it is advantageous that the provision of the optical monitor port at the second end part of the first waveguide section of the reflecting device does not necessarily require additional fabrication steps in many existing technologies mentioned above.

In an embodiment of the integrated photonic assembly according to the invention, the integrated photonic assembly is integrated on an Indium Phosphide (InP) based substrate. Examples of InP-based substrates comprise at least one of InP, Indium Gallium Arsenide Phosphide (InGaAsP) and Indium Aluminum Gallium Arsenide (InAIGaAs).

In an embodiment of the integrated photonic assembly according to the invention, the electromagnetic radiation in the optical monitor port has a wavelength in a range of 1300nm to 1625nm. Wavelengths in the aforementioned range are typically used in fiber optic telecommunication systems.

In an embodiment of the integrated photonic assembly according to the invention, the at least one reflecting device and the at least one photodetector component are monolithically integrated. In this way the integrated photonic assembly can be very compact.

In an embodiment of the integrated photonic assembly according to the invention, the at least one photodetector component is a photodiode.

According to another aspect of the present invention, an integrated semiconductor laser device is provided comprising an integrated photonic assembly according to the present invention, wherein the at least one reflecting device is arranged as a reflector of the integrated semiconductor laser device. It has been established that there is a strong correlation between the optical output power of the integrated semiconductor laser device and the measured photodiode current that is due to the electromagnetic radiation that impinges on the photodiode via the optical monitor port. Therefore, the measured photodiode current can be used to estimate the laser output power. This allows on-chip power monitoring for any type of integrated semiconductor laser device in which a reflecting device, e.g. a MIR, of the integrated photonic assembly according to the invention can be used as a reflector. Furthermore, in this way it is possible to monitor the performance of the integrated semiconductor laser device while it is operating.

In an embodiment of the integrated semiconductor laser device according to the invention, the integrated semiconductor laser device is a Distributed Bragg Reflector, DBR, laser device and the at least one reflecting device is arranged as a back-reflector of the DBR laser device. The person skilled in the art will appreciate that the integrated photonic assembly according to the invention is particularly suitable for application in DBR laser devices. By choosing the width of the second waveguide section of the optical monitor port in the abovementioned range of 10% to 20% of the width of the first waveguide section of the reflecting device, e.g. a MIR, regular operation of the DBR is not affected.

In an embodiment of the integrated semiconductor laser device according to the invention, the integrated semiconductor laser device is integrated on a substrate comprising at least one of a III-V semiconductor material, a silicon-based material, more particularly Silicon-On-insulator (SOI), a glass substrate and any dielectric material having a critical reflection angle larger than 45 degrees. The person skilled in the art will appreciate that when using III-V semiconductor material as a substrate the semiconductor laser device comprising the integrated photonic assembly can either be integrated monolithically or in a hybrid way. However, when using at least one of a silicon-based material, more particularly SOI, a glass substrate and any dielectric material having a critical reflection angle larger than 45 degrees, the semiconductor laser device comprising the integrated photonic assembly can only be integrated in a hybrid way because of at least one of the semiconductor laser device that requires the application of a direct bandgap semiconductor material and the photodetector component that requires the application of a semiconductor material.

In an embodiment of the integrated semiconductor laser device according to the invention, the integrated semiconductor laser device is monolithically integrated on a substrate comprising at least one of Indium Phosphide-based (InP) and Indium Aluminum Gallium Arsenide-based (InAlGaAs) semiconductor material. In an exemplary embodiment, the integrated semiconductor laser device is monolithically integrated on a substrate comprising Indium Gallium Arsenide Phosphide (InGaAsP) and InAlGaAs semiconductor material.

According to another aspect of the present invention, a photonic integrated circuit (PIC) is provided comprising at least one of the integrated photonic assembly and the integrated semiconductor laser device according to the present invention. In this way PICs can be achieved having an on-chip power monitoring capability.

According to another aspect of the present invention, a method is provided for fabricating an integrated photonic assembly, the method comprising the steps of providing at least one reflecting device for reflecting electromagnetic radiation using total internal reflection, the at least one reflecting device comprising a first waveguide section having a first end part and a second end part that are arranged opposite to each other, the first end part being provided with at least one optical input/output port, the second end part comprising at least a first pair of 45 degree mirrors that is arranged to reflect incident electromagnetic radiation towards the at least one optical input/output port, arranging an optical monitor port at the second end part between nearest end parts of the 45 degree mirrors of said at least first pair to receive a portion of the electromagnetic radiation in the first waveguide section, and providing at least one photodetector component in optical communication with the optical monitor port to detect said portion of electromagnetic radiation in the optical monitor port.

### BRIEF DESCRIPTION OF THE DRAWINGS

Further features and advantages of the invention will become apparent from the description of the invention by way of exemplary and non-limiting embodiments of an integrated photonic assembly and an integrated semiconductor laser device according to the invention.

The person skilled in the art will appreciate that the described embodiments are exemplary in nature only and not to be construed as limiting the scope of protection in any way. The person skilled in the art will realize that alternatives and equivalent embodiments of the integrated photonic assembly and the integrated laser device can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,

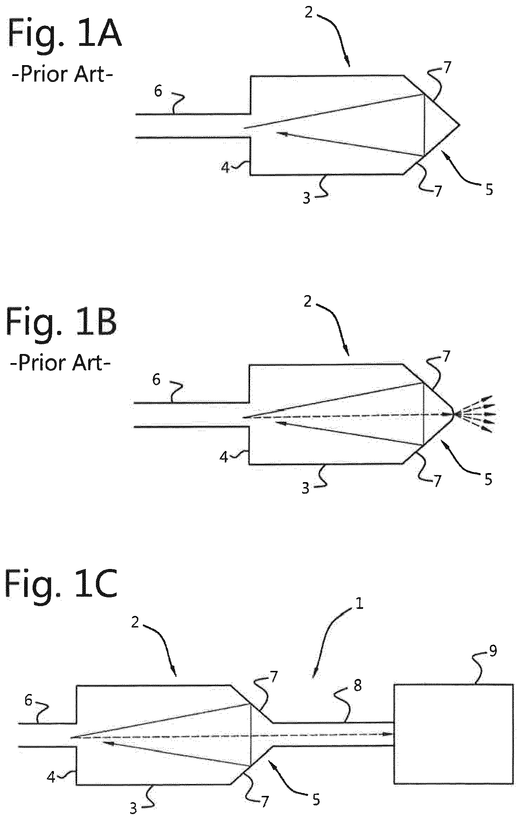

figure 1A shows a schematic representation of a known ideal reflecting device having one pair of 45 degree mirrors;
figure 1B shows a schematic representation of a known reflecting device having a rounded region between the nearest end parts of the two 45 degree mirrors due to limited lithographical resolution;
figure 1C shows a schematic representation of a first exemplary, non-limiting embodiment of an integrated photonic assembly according to the invention, wherein the reflecting device is a MIR that comprises one pair of 45 degree mirrors;

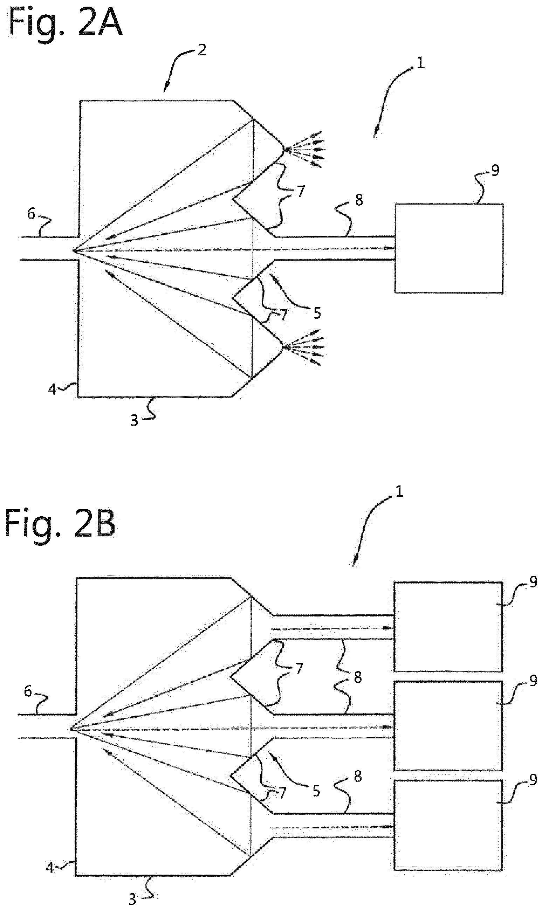

figure 2A shows a schematic representation of a second exemplary, non-limiting embodiment of the integrated photonic assembly according to the invention, wherein the reflecting device is a MIR that comprises three pairs of 45 degree mirrors of which there is one provided with an optical monitor port that is in optical communication with a photodetector component;
figure 2B shows a schematic representation of a third exemplary, non-limiting embodiment of the integrated photonic assembly according to the invention, wherein the reflecting device is a MIR that comprises three pairs of 45 degree mirrors that are all provided with a respective optical monitor port that is in optical communication with a respective photodetector component;

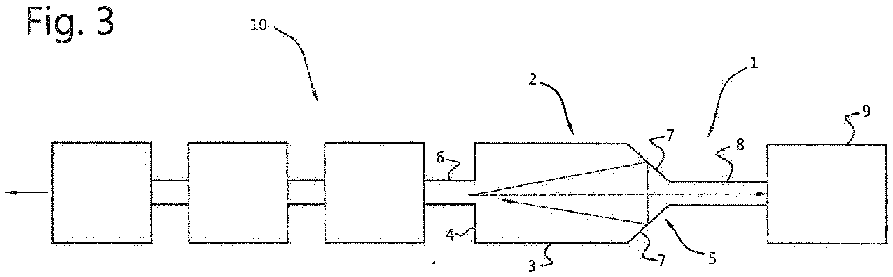

figure 3 shows a schematic representation of a first exemplary, non-limiting embodiment of an integrated semiconductor laser device according to the invention being a Distributed Bragg Reflector (DBR) laser device in which the reflecting device of the integrated photonic assembly is a MIR that comprises one pair of 45 degree mirrors and that is used as a back-reflector of the DBR;

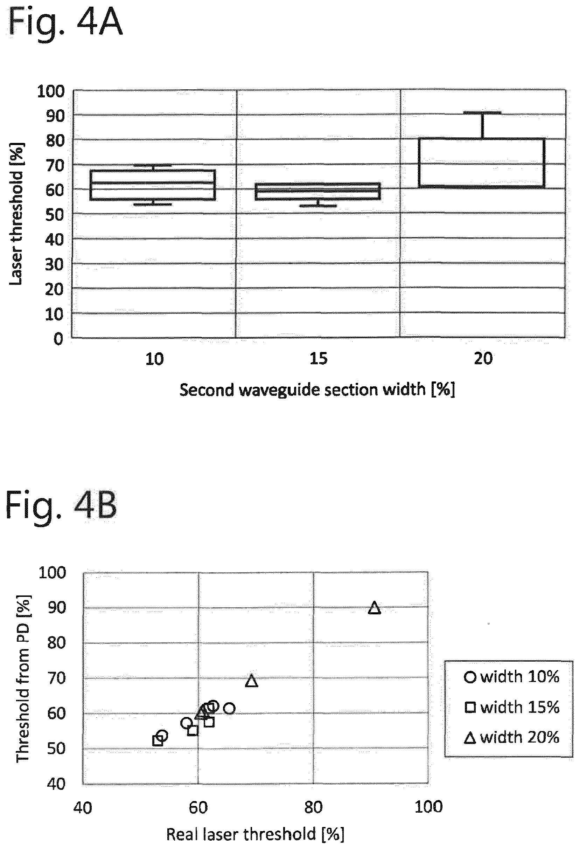

figure 4A shows the measured dependence of the relative laser threshold of DBR laser devices comprising the integrated photonic assembly according to the embodiment as shown in figure 3 on the width of the second waveguide section relative to the width of the first waveguide section; and
figure 4B shows for DBR laser devices comprising the integrated photonic assembly according to the embodiment as shown in figure 3 and having different widths of the second waveguide section, the correlation between the relative laser threshold that is measured using the photodetector component that is in optical communication with the second waveguide section of the optical monitor port and the relative real laser threshold that is measured using an external optical power meter.

### DETAILED DESCRIPTION OF EMBODIMENTS

Figure 1 a shows a schematic representation of a known ideal reflecting device 2, e.g a MIR. The reflecting device 2 comprises a first waveguide section 3 that has a first end part 4 and a second end part 5 that are arranged opposite to each other. The first end part 4 is provided with one optical input/output port 6. The person skilled in the art will appreciate that any suitable number of optical input/output ports can be provided depending on the requirements of a specific application. The second end part 5 comprises one pair of 45 degree mirrors 7 that are arranged to reflect incident electromagnetic radiation towards the optical input/output port 6. It can be observed that the point between the nearest end parts of the two 45 degree mirrors is sharp. As a result of that it would theoretically be possible to achieve reflections up to 100%. However, due to limited lithographical resolution, the point between the nearest end parts of the two 45 degree mirrors 7 is commonly not well defined and exhibits some rounding. This leads to a rounded region between the nearest end parts of the two 45 degree mirrors 7 as is schematically shown in figure 1 b. Although in a properly designed reflecting device 2, e.g. a MIR, the amount of electromagnetic radiation that ends up in this rounded region at the second end part 5 of the first waveguide section 3 is minimal, it never equals zero. The small amount of electromagnetic radiation that in use of the reflecting device 2 ends up in this rounded region is scattered out of the first waveguide section of the reflecting device and therefore is lost.

Figure 1c shows a schematic representation of a first exemplary, non-limiting embodiment of an integrated photonic assembly 1 according to the invention wherein the reflecting device 2 is a MIR that comprises one pair of 45 degree mirrors. The MIR has one optical input/output port 6 that is provided at the first end part 4 of the first waveguide section 3. Besides the two 45 degree mirrors 7 of said one pair of 45 degree mirrors, the second end part 5 of the first waveguide section 3 is provided with one optical monitor port 8 that is arranged between nearest end parts of the two 45 degree mirrors 7. The optical monitor port 8 is configured to receive a portion of the electromagnetic radiation in the first waveguide section that ends up in the region between the nearest end parts of the two 45 degree mirrors 7. The optical monitor port 8 is arranged in optical communication with one photodetector component 9, e.g. a photodiode, that is configured to detect the portion of electromagnetic radiation that is received in the optical monitor port 8. In this way, electromagnetic radiation that would otherwise be scattered out of the first waveguide section 3 in the rounded region between the nearest end parts of the two 45 degree mirrors 7 as shown in figure 1b for known reflecting devices, can be captured and used for optical monitoring purposes as described above.

In the first exemplary, non-limiting embodiment of the integrated photonic assembly 1 shown in figure 1c, the optical monitor port 8 is a single waveguide section having a width in a range of 10% to 20% of a width of the first waveguide section 3 of the MIR. The width of the single waveguide section determines the portion of the electromagnetic radiation that is tapped from the first waveguide section 3. This provides a design parameter that can be set depending on the requirements of a specific application. When choosing the width of the single waveguide section in the range mentioned above, the tapped portion of electromagnetic radiation is equal to or at least comparable with the amount of electromagnetic radiation that is scattered out of the first waveguide section 3 as is shown in figure 1b for known reflecting devices. In this way, the optical monitoring capability can be enabled without introducing any additional losses or at most low additional losses when compared to known MIRs lacking this capability.

Figure 2A shows a schematic representation of a second exemplary, non-limiting embodiment of the integrated photonic assembly 1 according to the invention, wherein the reflecting device 2 is a MIR. The reflecting device 2 comprises a first waveguide section 3 that has a first end part 4 and a second end part 5 that are arranged opposite to each other. The first end part 4 is provided with one optical input/output port 6. The second end part 5 comprises three pairs of 45 degree mirrors 7 that are arranged to reflect incident electromagnetic radiation towards the at least one optical input/output port 6. The pair of 45 degree mirrors that is arranged in the middle is provided with an optical monitor port 8 that is in optical communication with a photodetector component 9. In this way the electromagnetic radiation that is received in the optical monitor port 8 can be used for optical monitoring purposes as described above.

Figure 2B shows a schematic representation of a third exemplary, non-limiting embodiment of the integrated photonic assembly 1 according to the invention, wherein the reflecting device 2 is a MIR. The reflecting device 2 comprises a first waveguide section 3 that has a first end part 4 and a second end part 5 that are arranged opposite to each other. The first end part 4 is provided with one optical input/output port 6. The second end part 5 comprises three pairs of 45 degree mirrors 7 that are arranged to reflect incident electromagnetic radiation towards the at least one optical input/output port 6. All pairs of 45 degree mirrors are provided with a respective optical monitor port 8 that is in optical communication with a respective photodetector component 9. In this way the electromagnetic radiation that is received in the three optical monitor ports 8 can be used for optical monitoring purposes as described above.

The person skilled in the art will appreciate that many other configurations of the integrated photonic assembly 1 can be envisaged that fall within the scope of the present invention. These other configurations that are not described nor shown in any further detail, are determined by the requirements of the specific applications in which they are used.

Figure 3 shows a schematic representation of a first exemplary, non-limiting embodiment of an integrated semiconductor laser device 10 according to the invention being a Distributed Bragg Reflector (DBR) laser device in which the reflecting device 2 of the integrated photonic assembly 1 is a MIR that is used as a back-reflector. The person skilled in the art will appreciate that the integrated semiconductor laser device 10 of figure 3 is a non-limiting example of a photonic integrated circuit (PIC) according to the invention. As can be seen in figure 3 going from left to right, the DBR laser device comprises a front reflector via which the laser light exits the DBR laser device. The exiting laser light is indicated with an arrow. The front reflector is in optical communication with a phase section. The phase section is in optical communication with an optical gain section. The optical gain section is in optical communication with the reflecting device 2, i.e. the MIR, of the integrated photonic assembly 1. The person skilled in the art will appreciate that in another exemplary embodiment of the DBR laser device, the phase section could be omitted. Furthermore, the optical monitoring port 8 is a single waveguide section having a width in the range of 10% to 20% of the width of the first waveguide section 3 of the MIR.

As mentioned above, it has been established that there is a strong correlation between the optical output power of the integrated semiconductor laser device 10 and the measured photodiode current that is due to the electromagnetic radiation that impinges on the photodiode that is used as a photodetector component via the optical monitor port 8. Therefore, the measured photodiode current can be used to estimate the output power of the DBR laser device shown in figure 3.

Figure 4A shows the measured dependence of the relative laser threshold of DBR laser devices comprising the integrated photonic assembly 1 in an embodiment as shown in figure 3 on the width of the second waveguide section relative to the width of the first waveguide section. Figure 4A shows that for widths of the second waveguide section up to 15% of the width of the first waveguide section there is only little change in the relative laser threshold. For second waveguide sections having a width that is 20% of the width of the first waveguide section, there is a larger change in the relative laser threshold. The person skilled in the art will appreciate that a width of the second waveguide section that is 20% of the width of the first waveguide section is at the boundary of what is acceptable.

For DBR laser devices comprising the integrated photonic assembly 1 according to the embodiment as shown in figure 3 and having widths of the second waveguide section of 10%, 15% and 20% of the width of the first waveguide section, figure 4B shows the correlation between the relative laser threshold that is measured using the photodetector component that is in optical communication with the second waveguide section of the optical monitor port and the relative real laser threshold that is measured using an external optical power meter. As can be seen, there is a strong correlation for all the different widths of the second waveguide section. This means that the integrated photonic assembly according to the invention can advantageously be used for optical power monitoring of the DBR laser devices mentioned above.

The present invention can be summarized as relating to an integrated photonic assembly 1 for optical monitoring purposes, comprising at least one reflecting device 2 for reflecting electromagnetic radiation using total internal reflection that comprises a first waveguide section 3 having first 4 and second 5 end parts arranged opposite to each other, the first end part being provided with at least one optical input/output port 6, the second end part comprising at least a first pair of 45 degree mirrors 7 arranged to reflect incident electromagnetic radiation towards the at least one optical input/output port, wherein the second end part is provided with an optical monitor port 8 arranged between nearest end parts of the 45 degree mirrors of said at least first pair and configured to receive a portion of the electromagnetic radiation in the first waveguide section, and at least one photodetector component 9 that is in optical communication with the optical monitor port and is configured to detect said portion of electromagnetic radiation in the optical monitor port.

The invention also relates to an integrated semiconductor laser device 10 comprising the integrated photonic assembly, wherein the at least one reflecting device is arranged as a reflector of the integrated semiconductor laser device.

The invention further relates to a photonic integrated circuit (PIC) comprising at least one of the integrated photonic assembly and the integrated semiconductor laser device according to the invention.

The invention even further relates to a method for fabricating the integrated photonic assembly according to the invention.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

### REFERENCE NUMERALS

- 1: integrated photonic assembly
- 2: reflecting device
- 3: first waveguide section
- 4: first end part
- 5: second end part
- 6: optical input/output port
- 7: 45 degree mirror
- 8: optical monitor port
- 9: photodetector component
- 10: integrated semiconductor laser device

## Claims

1. An integrated photonic assembly (1) having optical monitoring capability, comprising:
- at least one reflecting device (2) for reflecting electromagnetic radiation using total internal reflection, comprising:
- a first waveguide section (3) having a first end part (4) and a second end part (5) that are arranged opposite to each other;
- the first end part (4) being provided with at least one optical input/output port (6);
- the second end part (5) comprising at least a first pair of 45 degree mirrors (7) that is arranged to reflect incident electromagnetic radiation towards the at least one optical input/output port (6), wherein the second end part (5) is provided with an optical monitor port (8) that is arranged between nearest end parts of the 45 degree mirrors (7) of said at least first pair and is configured to receive a portion of the electromagnetic radiation in the first waveguide section (3); and
- at least one photodetector component (9) that is in optical communication with the optical monitor port (8) and is configured to detect said portion of electromagnetic radiation in the optical monitor port (8).

2. The integrated photonic assembly (1) according to claim 1, wherein the optical monitor port (8) comprises at least a second waveguide section that is arranged between said nearest end parts of the 45 degree mirrors (7) of said at least first pair and that has a width in a range of 10% to 20% of a width of the first waveguide section (3).

3. The integrated photonic assembly (1) according to claim 1 or 2, wherein the at least one reflecting device (2) is a Multimode Interference Reflector, MIR.

4. The integrated photonic assembly (1) according to any one of the preceding claims, wherein the integrated photonic assembly is integrated on a substrate comprising at least one of a III-V semiconductor material, a silicon-based material, more particularly Silicon-On-Insulator, SOI, a glass substrate and any dielectric material having a critical reflection angle larger than 45 degrees.

5. The integrated photonic assembly (1) according to any one of claims 1 to 3, wherein the integrated photonic assembly (1) is integrated on an Indium Phosphide-based substrate.

6. The integrated photonic assembly (1) according to claim 4 or 5, wherein the electromagnetic radiation in the optical monitor port (8) has a wavelength in a range of 1300nm to 1625nm.

7. The integrated photonic assembly (1) according to any one of the preceding claims, wherein the at least one reflecting device (2) and the at least one photodetector component (9) are monolithically integrated.

8. The integrated photonic assembly (1) according to any one of the preceding claims, wherein the at least one photodetector component (9) is a photodiode.

9. An integrated semiconductor laser device (10) comprising an integrated photonic assembly (1) according to any one of the preceding claims, wherein the at least one reflecting device (2) is arranged as a reflector of the integrated semiconductor laser device (10).

10. The integrated semiconductor laser device (10) according to claim 9, wherein the integrated semiconductor laser device is a Distributed Bragg Reflector, DBR, laser device and the at least one reflecting device (2) is arranged as a back-reflector of the DBR laser device.

11. The integrated semiconductor laser device (10) according to claim 9 or 10, wherein the integrated semiconductor laser device is integrated on a substrate comprising at least one of a III-V semiconductor material, a silicon-based material, more particularly Silicon-On-Insulator, SOI, a glass substrate and any dielectric material having a critical reflection angle larger than 45 degrees.

12. The integrated semiconductor laser device (10) according to claim 9 or 10, wherein the integrated semiconductor laser device is monolithically integrated on a substrate comprising at least one of Indium Phosphide-based and Indium Aluminum Gallium Arsenide-based semiconductor material.

13. A photonic integrated circuit, PIC, comprising at least one of the integrated photonic assembly (1) according to any one of the claims 1 to 8 and the integrated semiconductor laser device (10) according to any one of the claims 9 to 12.

14. A method for fabricating an integrated photonic assembly (1) according to any one of the claims 1 to 7, the method comprising the steps of:
- providing at least one reflecting device (2) for reflecting electromagnetic radiation using total internal reflection, comprising:
- a first waveguide section (3) having a first end part (4) and a second end part (5) that are arranged opposite to each other;
- the first end part (4) being provided with at least one optical input/output port (6);
- the second end part (5) comprising at least a first pair of 45 degree mirrors (7) that is arranged to reflect incident electromagnetic radiation towards the at least one optical input/output port (6);
- arranging an optical monitor port (8) at the second end part (5) between nearest end parts of the 45 degree mirrors (7) of said at least first pair to receive a portion of the electromagnetic radiation in the first waveguide section (3); and
- providing at least one photodetector component (9) in optical communication with the optical monitor port (8) to detect said portion of electromagnetic radiation in the optical monitor port (8).
